# EUROPEAN PATENT SPECIFICATION

(11) **EP 4 141 951 B1**
(45) Date of publication and mention of the grant of the patent: **03.06.2026**
(21) Application number: 21808459.8
(22) Date of filing: 18.05.2021
(51) Int. Cl.: H10P 10/00, H10D 62/85, H10D 62/80

(54) **NITRIDE EPITAXIAL WAFER AND SEMICONDUCTOR DEVICE**
EPITAKTISCHER NITRIDWAFER UND HALBLEITERBAUELEMENT
TRANCHE ÉPITAXIALE DE NITRURE ET COMPOSANT SEMI-CONDUCTEUR

(30) Priority: 18.05.2020 CN 202010418395
(43) Date of publication of application: 01.03.2023
(73) Proprietor: Huawei Technologies Co., Ltd., Shenzhen, Guangdong 518129 (CN)
(72) Inventor: CHEN, Zhibin, Shenzhen, Guangdong 518129 (CN); HUANG, Boning, Shenzhen, Guangdong 518129 (CN)
(74) Representative: Pfenning, Meinig & Partner mbB
(86) International application number: PCT/CN2021/094407
(87) International publication number: WO 2021/233305

(56) References cited:
- WO-A1-2017/044577
- WO-A1-2019/178916
- WO-A1-2020/072871
- WO-A1-2021/009325
- CN-A- 101 931 035
- CN-A- 103 021 946
- CN-A- 106 960 781
- CN-A- 109 841 497
- CN-A- 111 682 061
- US-A1- 2013 288 458
- US-A1- 2021 020 428

## Description

### TECHNICAL FIELD

This application relates to the field of semiconductor technologies, and in particular, to a nitride epitaxial wafer, a manufacturing method thereof, and a semiconductor device.

### BACKGROUND

A gallium nitride (GaN) material is widely applied to a power device, a radio frequency device, and a photoelectric device because of advantages such as a broad band gap and high mobility. Currently, the gallium nitride material is usually obtained through epitaxial growth on a silicon substrate. However, because there is a large lattice mismatch of more than 17% and a thermal expansion coefficient mismatch between GaN and silicon, there is a large stress in gallium nitride on silicon. Due to the stress, warpage is generated during epitaxy, thereby affecting uniformity and reliability of a GaN epitaxial wafer. In addition, as a size of the substrate increases and a thickness of an epitaxial layer increases, a warpage problem becomes more serious. Therefore, it is necessary to find a gallium nitride epitaxial growth method that may be used to effectively relieve the stress and reduce occurrence of warpage. Some exemplary wafers are known from the following publications: US 2013/0288458 A1, WO 2017/044577 A1, WO 2020/072871 A1, WO 2021/009325 A1, and WO 2019/178916 A1.

### SUMMARY

The invention is defined by the appended set of claims. Embodiments of this application provide a nitride epitaxial wafer, a manufacturing method thereof, and a semiconductor device. A nucleation layer is disposed on a substrate, and a two-dimensional material layer is formed at the nucleation layer in a splicing or in-situ growth manner, to effectively relieve and release a stress generated due to a lattice mismatch and a thermal mismatch between the substrate and an epitaxial layer, reduce warpage existing in an epitaxy process and after epitaxy, improve uniformity and reliability of the nitride epitaxial wafer, and further improve performance of the semiconductor device.

According to a first aspect of the present invention a nitride epitaxial wafer as specified in claim 1 is provided.

The nucleation layer may provide a nucleation center for subsequent growth of a nitride epitaxial layer, to alleviate a lattice mismatch between the substrate and the epitaxial layer, and may be further used to effectively resist impact, on the subsequent growth of the nitride epitaxial layer, of an impurity brought by the substrate, to improve crystal quality of the epitaxial layer. However, the two-dimensional material layer may be used to directly release a stress through a lattice slip, to significantly reduce occurrence of warpage during epitaxy, and improve uniformity and crystal quality of the nitride epitaxial layer. In particular, the two-dimensional material layer formed in a splicing manner may be used to effectively reduce occurrence of warpage of a large-size (at least 6 inches) and thick-film (at least 5 µm) nitride epitaxial layer, to obtain a large-size, large-thickness, and high-quality nitride epitaxial wafer. However, the two-dimensional material layer formed in an in-situ growth manner can be used to effectively avoid a damage that may be caused in a two-dimensional material transfer process, and may be manufactured by using a deposition process like the epitaxial layer.

In an implementation of this application, the two-dimensional material layer is formed by splicing the plurality of small-size two-dimensional material films. When the two-dimensional material layer is formed by purposefully selecting and splicing a plurality of high-quality and small-size two-dimensional material films, a two-dimensional material layer with high overall quality may be obtained, to well release the stress, so as to smoothly manufacture and obtain a high-quality and large-size (at least 6 inches) nitride epitaxial wafer.

In an implementation of this application, a splicing gap exists between some or any two adjacent small-size two-dimensional material films. The splicing gap is disposed, to avoid an overlap at a splicing location at the two-dimensional material layer.

A width of the splicing gap is greater than or equal to 0.1 µm, and is less than or equal to 1/2 of a maximum distance between two points on the small-size two-dimensional material film. A size of the splicing gap is properly controlled, so that not only an overlap of the two-dimensional material can be avoided, but also a specific area percentage of the two-dimensional material layer at the nucleation layer can be better ensured, to help perform a stress release function of the two-dimensional material layer.

In some implementations of this application, an area percentage of the two-dimensional material layer at the nucleation layer is not less than 50%. The two-dimensional material layer has a specific area percentage at the nucleation layer, to help perform a stress release function of the two-dimensional material layer.

In some implementations of this application, a shape of the small-size two-dimensional material film may be a polygon. A film of a polygonal structure has a straight-line side, to better implement a splicing process, and better control uniformity of a width of a gap between two adjacent small-size two-dimensional material films. Specifically, in some implementations of this application, the shape of the small-size two-dimensional material film is an equilateral triangle, a right triangle, a regular hexagon, a square, a rectangle, or a diamond. Certainly, in this embodiment of this application, the shape of the small-size two-dimensional material film is not limited to the polygon, and may be another shape that may be used to implement splicing, for example, a circle.

In another implementation of this application, the two-dimensional material layer is formed by in-situ growing the two-dimensional material at the nucleation layer. Through in-situ growth, a complete two-dimensional material film can be directly manufactured and obtained through one time of deposition. A process operation is convenient.

In an implementation of this application, a material of the two-dimensional material layer includes at least one of graphene, boron nitride, silicene, germanene, phosphorene, borophene, stanene, a transition metal sulfide, a transition metal carbide, and a transition metal nitride.

The two-dimensional material layer is single-layer graphene.

In an implementation of this application, the material of the epitaxial layer is a group III metal nitride, and may specifically include one or more of GaN, AlN, InN, AlGaN, InGaN, InAlN, and InAlGaN.

In an implementation of this application, a thickness of the epitaxial layer is greater than or equal to 300 nm. Limited by the stress, a thickness of an existing gallium nitride epitaxial layer is usually small. The nitride epitaxial wafer in this embodiment of this application may be used to well remove the stress. Therefore, an infinite thickness can be achieved theoretically. In some implementations of this application, the thickness of the epitaxial layer may be greater than or equal to 5 µm, or may be greater than or equal to 10 µm.

In an implementation of this application, the substrate includes a silicon substrate, a sapphire substrate, a silicon on insulator substrate (SOI substrate), a gallium nitride substrate, a gallium arsenide substrate, an indium phosphide substrate, an aluminum nitride substrate, a silicon carbide substrate, a quartz substrate, or a diamond substrate.

In an implementation of this application, a thickness of the nucleation layer is 10 nm to 300 nm.

In an implementation of this application, the nitride epitaxial wafer further includes a transition layer disposed between the two-dimensional material layer and the epitaxial layer, and the transition layer is an aluminum nitride layer or a gallium nitride layer.

In an implementation of this application, the transition layer and the nucleation layer have a same material.

In an implementation of this application, a thickness of the transition layer is 10 nm to 300 nm.

**A** manufacturing method for a nitride epitaxial wafer may include:
forming a nucleation layer on a substrate, where the nucleation layer is an aluminum nitride layer or a gallium nitride layer;
transferring a plurality of small-size two-dimensional material films to the nucleation layer, and splicing the plurality of small-size two-dimensional material films to form a two-dimensional material layer; or in-situ growing a two-dimensional material at the nucleation layer, to form a two-dimensional material layer; and
epitaxially growing a group III metal nitride at the two-dimensional material layer, to form an epitaxial layer.

In an implementation of this application, the nucleation layer is manufactured in a physical vapor deposition or metalorganic chemical vapor deposition manner.

In an implementation of this application, the two-dimensional material is in-situ grown at the nucleation layer in a chemical vapor deposition manner, to form the two-dimensional material layer.

In an implementation of this application, the manufacturing method further includes: forming a transition layer between the two-dimensional material layer and the epitaxial layer, where the transition layer is an aluminum nitride layer or a gallium nitride layer.

A second aspect of embodiments of this application provides a semiconductor device, including the nitride epitaxial wafer according to the first aspect of embodiments of this application. The semiconductor device may be a power device, a radio frequency device, or a photoelectric device. Specifically, the semiconductor device is, for example, a field-effect transistor, a light emitting diode, or a laser diode.

According to the nitride epitaxial wafer and the manufacturing method provided in embodiments of this application, the nucleation layer and the two-dimensional material layer are sequentially disposed between the substrate and the nitride epitaxial layer, to directly release the stress through a lattice slip of the two-dimensional material, and reduce occurrence of warpage during epitaxy. A nitride epitaxial layer with high uniformity and high crystal quality is obtained through epitaxy on the substrate. In embodiments of this application, when epitaxy is performed on the nitride epitaxial wafer at a high temperature, occurrence of warpage can also be effectively reduced. In addition, because there is difficulty in manufacturing a large-size and high-quality single-layer two-dimensional material film currently, a large-size single-layer two-dimensional material film usually includes some pores (a nanoscale pore inevitably exists in a manufacturing process), resulting in a low film coverage rate. A polycrystal is easily grown at the pore, affecting a crystal quality of the subsequent epitaxial layer. In embodiments of this application, a small-size and high-quality two-dimensional material film is transferred to and spliced at the nucleation layer, to form the two-dimensional material layer, so that overall film quality of the two-dimensional material layer can be improved, and a higher single-layer coverage rate can be obtained, to better release the stress by using the two-dimensional material layer, and improve crystal quality of the nitride epitaxial layer. According to the manufacturing method provided in embodiments of this application, there is a simple process, and a requirement for large-scale production of a high-quality group III metal nitride material and an industrial device can be met. According to the semiconductor device provided in embodiments of this application, because the nitride epitaxial wafer provided in embodiments of this application is used, a device including a large-size thick nitride epitaxial layer can be obtained, to effectively reduce device costs, and improve device performance.

### BRIEF DESCRIPTION OF DRAWINGS

FIG. 1 is a schematic diagram of a structure of a nitride epitaxial wafer 100 according to an implementation of this application;
FIG. 2a to FIG. 2e are schematic diagrams of different splicing manners of a two-dimensional material layer according to an implementation of this application;
FIG. 3 is a schematic diagram of a structure of a nitride epitaxial wafer 100 according to another implementation of this application;
FIG. 4 is a flowchart of a manufacturing process of a nitride epitaxial wafer according to an implementation of this application;
FIG. 5 is a Raman scattering graph of a surface of an epitaxial layer of a nitride epitaxial wafer manufactured in Embodiment 1 of this application; and
FIG. 6 shows an atomic force microscope (Atomic Force Microscope, AFM) picture of a surface of an epitaxial layer of a nitride epitaxial wafer manufactured in Embodiment 1 of this application.

### DESCRIPTION OF EMBODIMENTS

The following describes embodiments of this application with reference to the accompanying drawings in embodiments of this application.

An embodiment of this application provides a nitride epitaxial wafer. The nitride epitaxial wafer includes a nitride epitaxial layer with high uniformity and high crystal quality, and may be applied to a semiconductor device, to improve device performance. In addition, the nitride epitaxial wafer may include a nitride epitaxial layer with a large size of at least 6 inches and a thickness of at least 5 micrometers.

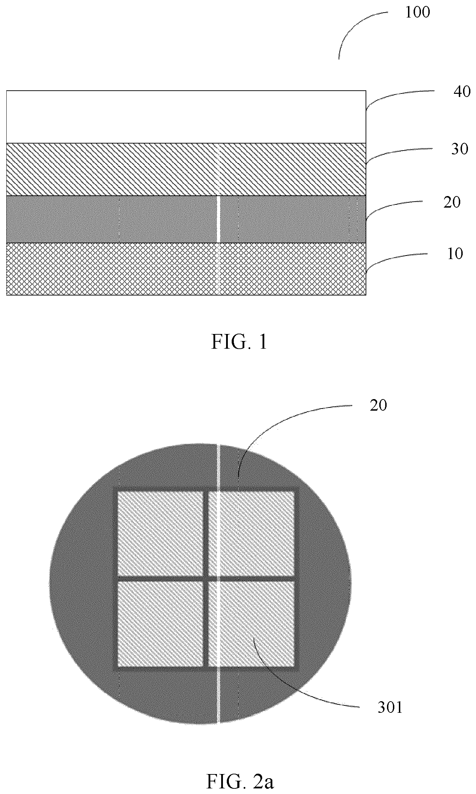

As shown in FIG. 1, a nitride epitaxial wafer 100 provided in an embodiment of this application includes a substrate 10, a nucleation layer 20, a two-dimensional material layer 30, and an epitaxial layer 40. The nucleation layer 20 is an AlN layer or a GaN layer, and is formed on the substrate 10. The two-dimensional material layer 30 is formed at the nucleation layer 20. The epitaxial layer 40 is formed at the two-dimensional material layer 30. A material of the epitaxial layer 40 includes a group III metal nitride.

In an implementation of this application, the substrate 10 may be a silicon substrate, a sapphire substrate, a silicon on insulator substrate (SOI substrate), a gallium nitride substrate, a gallium arsenide substrate, an indium phosphide substrate, an aluminum nitride substrate, a silicon carbide substrate, a quartz substrate, or a diamond substrate, or may be any existing known substrate that may be used to manufacture a group III metal nitride film. A crystal orientation of the silicon substrate is not limited, for example, may be a silicon substrate with a crystal face index (111), may be a silicon substrate with a crystal face index (100), or may be a silicon substrate with another crystal face index.

In an implementation of this application, the nucleation layer 20 is a layer of aluminum nitride or gallium nitride film, and the nucleation layer 20 completely covers the substrate 10. The nucleation layer 20 may provide a nucleation center for subsequent growth of the nitride epitaxial layer. In addition, the nucleation layer 20 may be used to relieve a stress generated due to a lattice mismatch between the substrate 10 and the epitaxial layer 40, and may be further used to effectively resist impact, on the subsequent growth of the nitride epitaxial layer, of an impurity brought by the substrate 10, to reduce lattice defects, decrease dislocation density, and improve crystal quality of the nitride epitaxial layer. In addition, the nucleation layer 20 is thin, and is single crystal or a quasi-single crystal. Therefore, the nucleation layer 20 may be used to relieve the stress generated due to the lattice mismatch between the substrate 10 and the epitaxial layer 40, to exert no impact on the crystal **quality** of the subsequent nitride epitaxial layer, and further effectively control costs. In some implementations of this application, a thickness of the nucleation layer 20 may be 10 nm to 300 nm. In some other implementations of this application, a thickness of the nucleation layer 20 may be 20 nm to 200 nm. In some other implementations of this application, a thickness of the nucleation layer 20 may be 50 nm to 150 nm.

In an implementation of this application, the nucleation layer 20 may be manufactured in a physical vapor deposition manner, or may be manufactured in a metalorganic chemical vapor deposition manner. Physical vapor deposition PVD (Physical Vapor Deposition) is a process in which a substance is transferred in a physical process, to transfer an atom or a molecule to a surface of a base material. A basic method of PVD includes vacuum evaporation, sputtering, ion plating (hollow cathode ion plating, hot cathode ion plating, arc ion plating, activated reactive ion plating, radio frequency ion plating, or direct current discharge ion plating), or the like. Metalorganic chemical vapor deposition (MOCVD, Metal-organic Chemical Vapor Deposition) is a chemical vapor deposition technology in which vapor epitaxial growth of a **film** is performed through thermal decomposition reaction of a metalorganic compound. Specifically, the metalorganic **compound** such as an organic compound of group III and group II elements and a hydride of group V and group VI elements may be used as a crystal growth source material, to grow a group III-V compound film and a **group** II-VI compound film on the substrate through thermal decomposition reaction. The metalorganic chemical vapor deposition manner may be used to improve the crystal quality of a subsequent nitride at the epitaxial layer. In the physical vapor deposition manner, a process is simple, and the entire nitride epitaxial wafer can be manufactured by performing only one time of epitaxy, without a need to perform a second time of epitaxy, to reduce epitaxy costs.

In an implementation of this **application,** a **material** of the two-dimensional material layer 30 may specifically include at least one of graphene, boron nitride, silicene, germanene, phosphorene, borophene, stanene, a transition metal sulfide, a transition metal carbide, and a transition metal nitride. The two-dimensional material layer 30 is formed at the nucleation layer 20, and may be used to release the stress through van der Waals epitaxy, and renucleation does not need to be performed for subsequent growth of the epitaxial layer 40. The van der Waals epitaxy is an interatomic force. In other words, atoms do not bond with each other. The two-dimensional material layer 30 is inserted between two layers of nitrides of the nucleation layer 20 and the epitaxial layer 40, so that a two-dimensional material of the two-dimensional material layer 30 and the two layers of nitrides of the nucleation layer 20 and the epitaxial layer 40 do not directly bond with each other. Therefore, there is no stress. A stress caused by the lattice mismatch is removed through stretching and slipping of the two-dimensional material.

two-dimensional material layer is a single-layer two-dimensional material, for example, is single-layer graphene, single-layer boron nitride, a single-layer transition metal sulfide, and single-layer blue apatite. The single-layer two-dimensional material can used to better obtain an epitaxial layer with high crystal quality, to improve uniformity of a nitride film at the epitaxial layer. However, it should be noted that, because a manufacturing process of a two-dimensional material film is limited currently, not every part of the two-dimensional material layer 30 may be a single layer, and there may be a small quantity of regions in which there are at least two layers. In this implementation of this application, the two-dimensional material layer 30 may be a doped two-dimensional material. A doped element may be various elements of a known two-dimensional material that may be doped, and the doped two-dimensional material may be, for example, nitrogen-doped graphene.

In this implementation of this application, when the thickness of the two-dimensional material layer 30 is less than or equal to 1 nm, in other words, when a spacing between two layers, namely, a lower layer and an upper layer, of nitrides of the nucleation layer 20 and the epitaxial layer 40 is less than or equal to 1 nm, there is a remote epitaxy state. To be specific, an atom at the lower layer, namely, the nucleation layer still exerts a weak acting force on an atom at an upper layer, so that the atom at the upper layer still grows based on an arrangement of the atom at the lower layer, to avoid degrading the crystal quality, and obtain a high-quality epitaxial layer. When the two-dimensional material layer is too thick, the upper layer of nitride completely loses an acting force exerted by the lower layer of nitride, and a polycrystal is easily formed. The single-layer two-dimensional material has a thinner thickness, so that an atom at the nucleation layer exerts a stronger acting force on an atom at the epitaxial layer, which is more conducive to improving the crystal quality of the epitaxial layer. However, if the two-dimensional material layer includes a void (including a splicing gap and a pore), namely, a region whose thickness is 0, an acting force is generated between the upper layer of nitride and the lower layer of nitride, and a stress is introduced. However, as a whole, provided that a void percentage falls within a specific range, the stress can still be reduced. However, due to an overlap, release of the stress is greatly affected, and an acting force is lost between the epitaxial layer and the nucleation layer. Consequently, the polycrystal is generated, and the crystal quality of the epitaxial layer is reduced. Therefore, impact of an overlap of the two-dimensional material is far greater than that of the void.

In addition, because there is difficulty in manufacturing a large-size single-layer two-dimensional material film currently, it is difficult to obtain high quality. Usually, a film includes some overlapping regions and pore regions, and the polycrystal is easily generated due to the overlapping region and the pore region. In an implementation of this application, to obtain a large-size high-quality nitride epitaxial wafer, the two-dimensional material layer 30 is formed by transferring a plurality of small-size two-dimensional material films to the nucleation layer 20 and splicing the plurality of small-size two-dimensional material films. The two-dimensional material layer is formed in a splicing manner. A small-size high-quality (there is no overlap or a very small quantity of overlaps, and few pores) two-dimensional material film may be purposefully selected, and is transferred to and spliced at the nucleation layer to form the two-dimensional material layer, to improve quality of the two-dimensional material layer, and reduce an area percentage of the overlapping region. In addition, a higher single-layer coverage rate can be obtained in a case of few pores, to better release the stress by using the two-dimensional material layer, and improve the crystal quality of the nitride epitaxial layer.

In an implementation of this application, a specific shape and size of the small-size two-dimensional material film used for splicing are not limited, and the small-size two-dimensional material film may be in any shape. In some implementations of this application, a shape of the small-size two-dimensional material film is a polygon. A film of a polygonal structure has a straight-line side, to better implement a splicing process, and better control uniformity of a width of a gap between two adjacent small-size two-dimensional material films. In some implementations of this application, the polygon includes an internal angle that may be divided by 360°, to better adapt to a circular substrate. To better implement splicing, a small-size two-dimensional material film in a regular shape that may be obtained through cutting may be selected. It can be understood that a more regular and symmetrical shape is more conducive to cutting and splicing, and provides a more regular peripheral contour of a finally formed two-dimensional material layer, to better control growth and manufacturing of the epitaxial layer, and reduce a material loss during final cutting (usually, an edge is cut off after the epitaxial layer and a subsequent functional layer are manufactured).

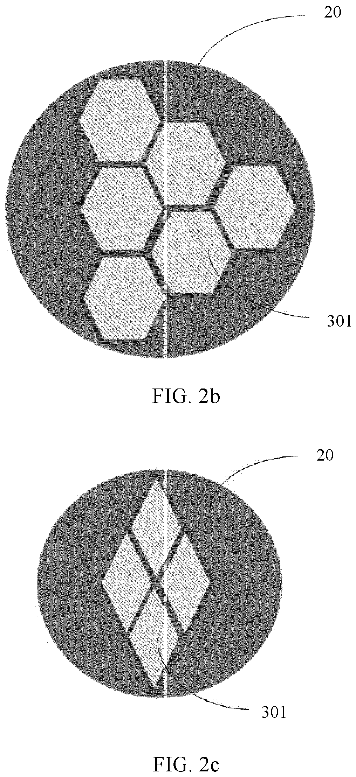

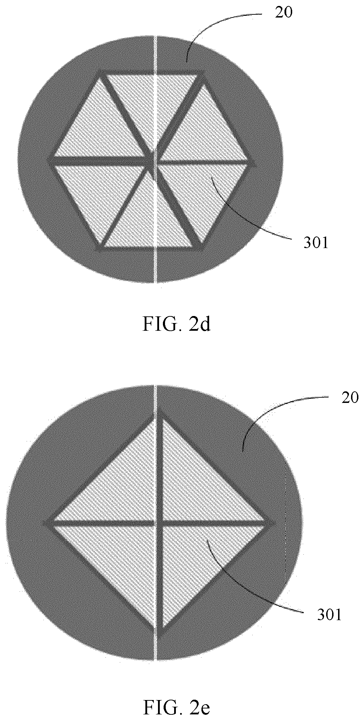

In an implementation of this application, the shape of the small-size two-dimensional material film may be specifically but is not limited to an equilateral triangle, a right triangle, a regular hexagon, a square, a rectangle, or a diamond. As shown in FIG. 2a, a shape of a small-size two-dimensional material film 301 is a rectangle, and a plurality of rectangular small-size two-dimensional material films 301 are sequentially arranged, to form a two-dimensional material layer 30 whose peripheral contour is a rectangle. As shown in FIG. 2b, a shape of a small-size two-dimensional material film 301 is a regular hexagon. As shown in FIG. 2c, a shape of a small-size two-dimensional material film 301 is a diamond. As shown in FIG. 2d, a shape of a small-size two-dimensional material film 301 is an equilateral triangle. As shown in FIG. 2e, a shape of a small-size two-dimensional material film 301 is a right triangle. It should be noted that FIG. 2a to FIG. 2e are merely schematic diagrams in which small-size two-dimensional material films 301 are spliced in some implementations of this application. A specific splicing form, the shape of the small-size two-dimensional material film, a quantity of small-size two-dimensional material films, the peripheral contour of the two-dimensional material layer in this embodiment of this application are not limited to those shown in the figures. A size of the small-size two-dimensional material film 301 may be properly selected based on a size of the substrate and quality of the two-dimensional material film. In some implementations of this application, the size of the small-size two-dimensional material film may be 1 mm to 100 mm. The small-size high-quality two-dimensional material film is transferred to and spliced at the nucleation layer to form the two-dimensional material layer, to improve quality of the two-dimensional material layer, obtain a higher single-layer coverage rate, and effectively avoid disadvantages of the single-layer two-dimensional material such as a small size and an insufficient coverage rate. In this application, a solution of forming the two-dimensional material layer in the splicing manner is especially applicable to manufacturing of a large-size nitride epitaxial wafer that is 6 inches, 8 or more inches.

In some implementations of this application, a plurality of small-size two-dimensional material films 301 that are spliced to form the two-dimensional material layer 30 may not all have a same shape. For example, the two-dimensional material layer 30 may include small-size two-dimensional material films 301 having at least two different shapes, for example, include both a rectangle and a triangle.

The two-dimensional material layer 30 is a non-continuous film. The two-dimensional material layer 30 does not completely cover the nucleation layer 20, and a specific distance may be reserved between an outer edge of the two-dimensional material layer 30 and an outer edge of the nucleation layer 20.

In an implementation of this application, a splicing gap is reserved between some or any two adjacent small-size two-dimensional material films 301. A specific splicing gap is disposed, to avoid forming an overlap of the two-dimensional material at a splicing location, so as to facilitate subsequent growth of the nitride epitaxial layer, and improve the crystal quality.

The width of the splicing gap is greater than or equal to 0.1 µm, and is less than or equal to 1/2 of a maximum distance between two points on the small-size two-dimensional material film. That the shape of the small-size two-dimensional material film is a square is used as an example. The width of the splicing gap is smaller than a radius of a circumscribed circle of the square. A size of the splicing gap is properly controlled, so that not only the overlap of the two-dimensional material can be avoided, but also a specific area percentage of the two-dimensional material layer at the nucleation layer can be better ensured, to help perform a stress release function of the two-dimensional material layer. For ease of operation and control, in some implementations of this application, the splicing gap may be greater than or equal to 0.5 mm, for example, is specifically 1 mm to 20 mm.

In some implementations of this application, an area percentage of the two-dimensional material layer 30 at the nucleation layer 20 is not less than 50%. The two-dimensional material layer 30 has a specific area percentage at the nucleation layer 20, to help perform a stress release function of the two-dimensional material layer 30. In some other implementations of this application, an area percentage of the two-dimensional material layer 30 at the nucleation layer 20 is greater than 70%.

In another implementation of this application, the two-dimensional material layer 30 is formed through in-situ growth at the nucleation layer 20. In this implementation, the two-dimensional material layer 30 is usually a continuous film as a whole. In some implementations, a non-continuous film may alternatively be formed due to a process operation problem. The two-dimensional material layer 30 may be obtained through in-situ growth performed in a chemical vapor deposition manner. A process in which the two-dimensional material grows usually includes a formation-expansion-merge process of a nucleation point. In this embodiment of this application, an in-situ growth manner is especially applicable to a nitride two-dimensional material, for example, boron nitride. Because the two-dimensional material layer and the epitaxial layer are both nitrides, two-dimensional material layer may also be manufactured in the metalorganic chemical vapor deposition manner like the epitaxial layer, to simplify a process operation of an entire film of the epitaxial wafer.

In an implementation of this application, the material of the epitaxial layer 40 includes a group III metal nitride, and may be specifically one or more of GaN, AlN, InN, AlGaN, InGaN, InAlN, and InAlGaN. A thickness of the epitaxial layer 40 is greater than or equal to 300 nm. Limited by the stress, a thickness of an existing gallium nitride epitaxial layer is usually small. The nitride epitaxial wafer in this embodiment of this application may be used to well remove the stress. Therefore, the nitride epitaxial wafer may be applied to manufacturing of a thick-film epitaxial layer, and an infinite thickness can be achieved theoretically. In some implementations of this application, the thickness of the epitaxial layer may be greater than or equal to 5 µm, or may be greater than or equal to 10 µm, for example, 15 µm to 100 µm. In this embodiment of this application, an entire surface of the epitaxial layer 40 is flat, and a splicing gap of the two-dimensional material does not affect continuous film formation of a nitride at the epitaxial layer. The epitaxial layer 40 partially covers the nucleation layer 20, and is basically the same as the peripheral contour of the two-dimensional material layer 30.

In an implementation of this application, different nitride epitaxial layers may be applied to different semiconductor devices. For example, GaN, AlGaN, and AlN may be applied to a power device, and a nitride epitaxial layer including In may be applied to a photoelectric device.

In an implementation of this application, to meet a use performance requirement, another element may be doped to the epitaxial layer 40. For example, to improve insulation, carbon may be doped to form high resistance, so as to improve withstanding voltage performance.

In an implementation of this application, because there is a weak van der Waals force between the epitaxial layer 40 and the two-dimensional material layer 30, the epitaxial layer 40 is easily peeled off and transferred to another target substrate, may be used to repeatedly use the original substrate 10, and may be further used to manufacture a gallium nitride self-supporting substrate and a flexible device.

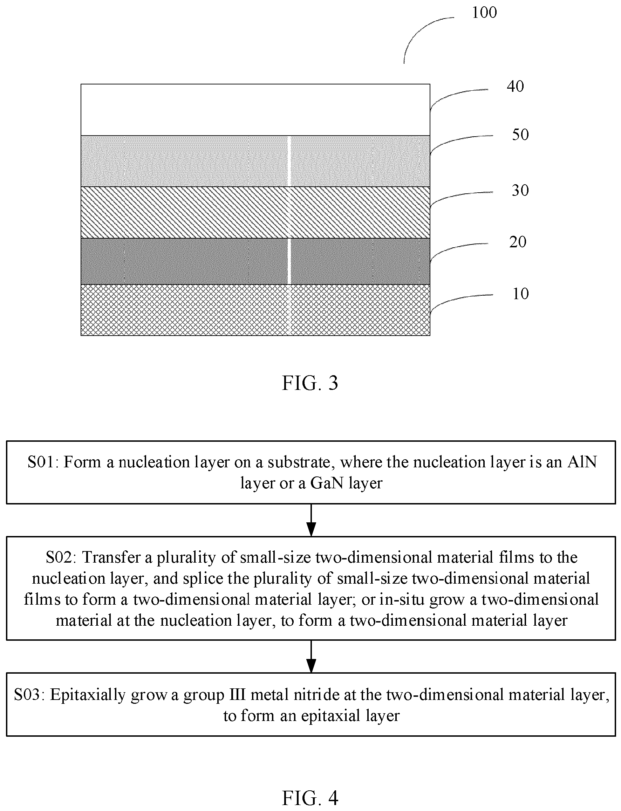

In some implementations of this application, as shown in FIG. 3, the nitride epitaxial wafer 100 further includes a transition layer 50 disposed between the two-dimensional material layer 30 and the epitaxial layer 40. The transition layer 50 may be an AlN layer, or may be a GaN layer. A thickness of the transition layer may be 10 nm to 300 nm. The transition layer 50 is disposed, to effectively block an impurity introduced by the two-dimensional material layer 30, and improve the crystal quality of the nitride epitaxial layer. In addition, because the two-dimensional material layer includes a specific splicing gap and a pore (a nanoscale pore inevitably exists in a manufacturing process, and a size is usually tens or hundreds of nanometers), after the transition layer 50 is disposed, good crystal quality is achieved at a location that is at the two-dimensional material layer and that is not covered. In addition, a material of the transition layer 50 is the same as a material of the nucleation layer 20. In other words, the transition layer 50 and the nucleation layer 20 each are an AlN layer or a GaN layer. In this case, the two-dimensional material layer 30 may be located in the middle of a homogeneous layer, to improve the crystal quality of the subsequent nitride epitaxial layer 40.

In an implementation of this application, when the epitaxial layer 40 needs to be peeled off for use, the transition layer 50 and the epitaxial layer 40 are peeled off together from the two-dimensional material layer 30.

According to the nitride epitaxial wafer provided in this embodiment of this application, the nucleation layer and the two-dimensional material layer are sequentially disposed between the substrate and the nitride epitaxial layer, the stress generated due to the lattice mismatch is relieved by using the nucleation layer, and the stress is directly released through a lattice slip of the two-dimensional material, to reduce occurrence of warpage during epitaxy, and obtain a nitride epitaxial layer with high uniformity and high crystal quality. The nucleation layer may provide the nucleation center for subsequent growth of the nitride epitaxial layer, to alleviate the lattice mismatch between the substrate and the epitaxial layer, and may be further used to effectively resist impact, on the subsequent growth of the nitride epitaxial layer, of an impurity brought by the substrate, to improve the crystal quality of the epitaxial layer. However, the two-dimensional material layer may be used to directly release the stress through the lattice slip, to significantly reduce occurrence of warpage during epitaxy, and improve uniformity and crystal quality of the nitride epitaxial layer. In particular, the two-dimensional material layer formed in the splicing manner may be used to effectively reduce occurrence of warpage of a large-size (at least 6 inches) and thick-film (at least 5 µm) nitride epitaxial layer, to obtain a large-size, large-thickness, and high-quality nitride epitaxial wafer. However, the two-dimensional material layer formed in the in-situ growth manner can be used to effectively avoid a damage that may be caused in a two-dimensional material transfer process, and may be manufactured by using a deposition process like the epitaxial layer.

Correspondingly, as shown in FIG. 4, an embodiment of this application further provides a manufacturing method for a nitride epitaxial wafer, including the following steps.

S01: Form a nucleation layer on a substrate, where the nucleation layer is an AlN layer or a GaN layer.

Specifically, a nucleation layer 20 may be specifically manufactured on a substrate 10 in a physical vapor deposition manner or a metalorganic chemical vapor deposition manner. Before the nucleation layer 20 is manufactured, conventional cleaning processing may be first performed on the substrate 10.

In a specific implementation of this application, the nucleation layer 20 is manufactured on the substrate 10 in a magnetron sputtering manner. Specifically, the substrate 10 may be disposed in a magnetron sputtering system. Pressure of a reaction chamber is 0.8 Pa to 1 Pa, and nitrogen and oxygen are injected for 3 minutes to 5 minutes, to obtain a processed substrate 10. Then, aluminum or gallium whose purity is 99.999% is used as a target, and aluminum nitride or gallium nitride is obtained in a magnetron sputtering manner on the processed substrate 10, to obtain the nucleation layer 20. An operation parameter in a magnetron sputtering process may be set based on an actual requirement, is not specifically limited in this embodiment of this application, and is not limited to the foregoing range. In some other implementations of this application, the nucleation layer 20 may alternatively be manufactured in another physical vapor deposition manner.

In another specific implementation of this application, the nucleation layer 20 is manufactured on the substrate 10 in the metalorganic chemical vapor deposition manner. Specifically, the substrate 10 may be disposed in a metalorganic chemical vapor deposition reaction chamber, hydrogen and ammonia are injected for 3 minutes to 5 minutes at a temperature of 900°C to 1100°C and under pressure of 30 Torr to 60 Torr, to obtain a processed substrate 10, and then hydrogen, ammonia, an aluminum source, or a gallium source is injected, to obtain aluminum nitride or gallium nitride through deposition on the processed substrate 10, so as to obtain the nucleation layer 20. In this implementation of this application, various parameters in a deposition process are not limited to the foregoing range. The gallium source includes but is not limited to trimethylgallium and triethylgallium. The aluminum source includes but is not limited to trimethylaluminium and triethylaluminium.

S02: Form a two-dimensional material layer at the nucleation layer.

In an implementation of this application, a method for forming a two-dimensional material layer 30 at the nucleation layer 20 is: transferring a plurality of small-size two-dimensional material films to the nucleation layer 20, and splicing the plurality of small-size two-dimensional material films to form the two-dimensional material layer 30.

Graphene is used as an example. The graphene may be grown on a metal substrate (for example, a copper foil) by using without limitation to a chemical vapor deposition manner. Specifically, in a reaction chamber at 800°C to 1000°C, a carbon source is injected into the reaction chamber, and the carbon source may be a gas including carbon, for example, methane, ethylene, or acetylene. The metal substrate on which graphene is grown is disposed in a mixed solution of 1 mol/L iron oxide and 2 mol/L hydrochloric acid for 12 hours to remove the metal substrate, to obtain graphene from which the metal substrate is removed. Then, a high-quality part of graphene is selected and cut to obtain a plurality of high-quality and small-size graphene films, and the plurality of small-sized graphene films are transferred to the nucleation layer 20 and spliced to obtain a two-dimensional material layer of a target size. Because it is difficult to manufacture a large-size high-quality graphene film currently, to obtain a two-dimensional material layer of a large target size through splicing, a graphene film may be manufactured for a plurality of times for cutting, to obtain the plurality of high-quality and small-size graphene films. To better implement splicing, the plurality of high-quality and small-size graphene films may be cut into a same regular shape. The two-dimensional material layer formed through splicing is a non-continuous film, and a splicing gap is formed between adjacent small-size graphene films 301. The splicing gap is specifically disposed as above.

In another implementation of this application, a method for forming a two-dimensional material layer 30 at the nucleation layer 20: in-situ growing a two-dimensional material at the nucleation layer 20, to form the two-dimensional material layer 30. Specifically, the two-dimensional material may in-situ grow in the chemical vapor deposition manner. Boron nitride may in-situ grow in the metalorganic chemical vapor deposition reaction chamber, to implement single-step epitaxy, simplify a process, and reduce costs. A specific operation of in-situ growing various two-dimensional materials may be performed in an existing known manner, and is not specifically limited in this application.

S03: Epitaxially grow a group III metal nitride at the two-dimensional material layer, to form an epitaxial layer.

In an implementation of this application, the epitaxial layer 40 may be manufactured in the metalorganic chemical vapor deposition manner. Specifically, the substrate 10 obtained after step S02 is disposed in the metalorganic chemical vapor deposition reaction chamber, and hydrogen and ammonia are injected for 3 minutes to 5 minutes at a temperature of 900°C to 1100°C and under pressure of 30 Torr to 60 Torr, to obtain the processed substrate 10. Then, hydrogen, ammonia, and a group III metal source are injected, to epitaxially grow the group III metal nitride at the two-dimensional material layer 30, to form the epitaxial layer 40. The group III metal nitride may be specifically, for example, one or more of GaN, AlN, InN, AlGaN, InGaN, InAlN, and InAlGaN. The group III metal source is an organic compound including a group III metal element, for example, trimethylgallium, triethylgallium, trimethylaluminium, or triethylaluminium.

In an implementation of this application, the manufacturing method may further include: forming a transition layer 50 between the two-dimensional material layer 30 and the epitaxial layer 40. In other words, before step S03, one transition layer 50 is first manufactured at the two-dimensional material layer 30, and the epitaxial layer 40 is grown at the transition layer 50. A material of the transition layer 50 may be an AlN layer or a GaN layer. To improve crystal quality of an epitaxial layer at the splicing gap, optionally, the material of the transition layer 50 is the same as a material of the nucleation layer 20. The transition layer 50 may be specifically a high-temperature aluminum nitride layer or a high-temperature gallium nitride layer, and the transition layer 50 may be an AlN layer or a GaN layer having a high V/III percentage.

In a solution in which the two-dimensional material layer is formed in a transfer and splicing manner, the transition layer 50 is disposed, to avoid an electric leakage risk caused by a large quantity of impurities introduced by the two-dimensional material. The transition layer 50 may serve as an impurity blocking layer, to improve crystal quality of a subsequent nitride epitaxial layer.

However, in a solution in which the two-dimensional material layer is formed in an in-situ growth manner, the transition layer 50 may serve as an impurity blocking layer. In addition, a specific amount of carbon is doped to the transition layer 50 to form high resistance, to improve a withstanding voltage capability of the nitride epitaxial layer.

An embodiment of this application further provides a semiconductor device, including the nitride epitaxial wafer provided in embodiments of this application. The nitride epitaxial wafer in embodiments of this application may be directly used as a part of the semiconductor device, or an epitaxial layer may be peeled off and applied to the semiconductor device. The semiconductor device includes but is not limited to a power device, a radio frequency device, or a photoelectric device. The power device and the radio frequency device each may be a transistor, and each may be specifically a field-effect transistor, for example, a high electron mobility transistor (High Electron Mobility Transistor, HEMT). The photoelectric device is, for example, a light emitting diode (Light Emitting Diode, LED) or a laser diode (Laser diode, LD). Specifically, the photoelectric device may be a nitride-based light emitting diode or a nitride-based quantum well laser diode.

For example, in an implementation of this application, the semiconductor device is a light emitting diode, and the light emitting diode includes the nitride epitaxial wafer provided in embodiments of this application, a quantum well active region, or the like that is epitaxially grown at the epitaxial layer, a P electrode, an N electrode, or the like.

The following further describes solutions of this application by using a plurality of embodiments.

### Embodiment 1

A manufacturing method for a nitride epitaxial wafer includes:
(1) A silicon substrate whose size is 8 inches is disposed in a magnetron sputtering system, pressure of a reaction chamber is 1 Pa, nitrogen and oxygen are injected for 5 min, aluminum whose purity is 99.999% is used as a target, and magnetron sputtering of aluminum nitride is performed on the silicon substrate, to obtain an aluminum nitride nucleation layer whose thickness is 25 nm.
(2) Single-layer graphene is grown on a copper foil in a chemical vapor deposition manner, a high-quality part is selected and cut into a square, and the copper foil is etched and removed to obtain a small-size high-quality single-layer graphene film. After a plurality of small-size high-quality single-layer graphene films of a required size are obtained in the foregoing method, the obtained plurality of small-size high-quality single-layer graphene films are transferred to the aluminum nitride nucleation layer, and are sequentially spliced in a manner in FIG. 2a, to obtain a single graphene layer, a size of each block of small-size graphene is 1 cm*1 cm, and a splicing gap between any two adjacent small-size single-layer graphene films is controlled to fall within 0.2 cm. An area percentage of the graphene layer on the whole aluminum nitride nucleation layer is approximately 80%.
(3) The silicon substrate on which the graphene layer is formed is disposed in a metalorganic chemical vapor deposition reaction chamber, hydrogen, ammonia, and a gallium source are injected at a temperature of 1100°C and under pressure of 50 Torr, and a 10 nm aluminum nitride transition layer and a 5 µm gallium nitride epitaxial layer sequentially grow at the graphene layer.

### Embodiment 2

A manufacturing method for a nitride epitaxial wafer includes:
(1) A silicon substrate whose size is 8 inches is disposed in a metalorganic chemical vapor deposition reaction chamber, hydrogen, ammonia, and trimethylaluminium are injected at a temperature of 900°C to 1100°C and under pressure of 30 Torr to 60 Torr, and an aluminum nitride nucleation layer whose thickness is 150 nm is obtained through deposition on the substrate.
(2) The silicon substrate is taken out of the metalorganic chemical vapor deposition reaction chamber, and single-layer graphene is in-situ grown at the nucleation layer in a chemical vapor deposition manner.
(3) A silicon substrate on which a graphene layer is formed is disposed in the metalorganic chemical vapor deposition reaction chamber, hydrogen, ammonia, and trimethylgallium are injected at a temperature of 1100°C and under pressure of 50 Torr, and a gallium nitride epitaxial layer whose thickness is 2 µm grows at the graphene layer.

### Embodiment 3

A manufacturing method for a nitride epitaxial wafer includes:
(1) A silicon substrate whose size is 8 inches is disposed in a metalorganic chemical vapor deposition reaction chamber, and epitaxy of aluminum nitride is performed on the silicon substrate, to obtain an aluminum nitride nucleation layer whose thickness is 200 nm.
(2) Epitaxy of a layer of two-dimensional boron nitride whose thickness is less than 1 nm is performed at the aluminum nitride nucleation layer.
(3) The silicon substrate on which boron nitride is formed is injected with hydrogen, ammonia, and an aluminum source at a temperature of 1100°C and under pressure of 50 Torr, and an aluminum nitride transition layer whose thickness is 10 nm is obtained through deposition at a boron nitride layer.
(4) Hydrogen, ammonia, and a gallium source continue to be injected into the metalorganic chemical vapor deposition reaction chamber at the temperature of 1100°C and under pressure of 50 Torr, and a gallium nitride epitaxial layer whose thickness is 2 µm to 6 µm grows at the aluminum nitride transition layer.

### Embodiment 4

A manufacturing method for a nitride epitaxial wafer includes:
(1) A silicon substrate whose size is 8 inches is disposed in a metalorganic chemical vapor deposition reaction chamber, and epitaxy of aluminum nitride is performed on the silicon substrate, to obtain an aluminum nitride nucleation layer whose thickness is 200 nm.
(2) Single-layer graphene grows at the aluminum nitride nucleation layer in a chemical vapor deposition manner, and a thickness of graphene is not greater than 1 nm.
(3) The silicon substrate on which graphene is formed is disposed in the metalorganic chemical vapor deposition reaction chamber; at a temperature of 1100°C and under pressure of 50 Torr, hydrogen and ammonia are injected for 4 min, and then hydrogen, ammonia, and an aluminum source are injected; and an aluminum nitride transition layer whose thickness is 10 nm is obtained through deposition at a graphene layer.
(4) Hydrogen, ammonia, and a gallium source continue to be injected into the metalorganic chemical vapor deposition reaction chamber at the temperature of 1100°C and under pressure of 50 Torr, and a gallium nitride epitaxial layer whose thickness is 2 µm to 6 µm grows at the aluminum nitride transition layer.

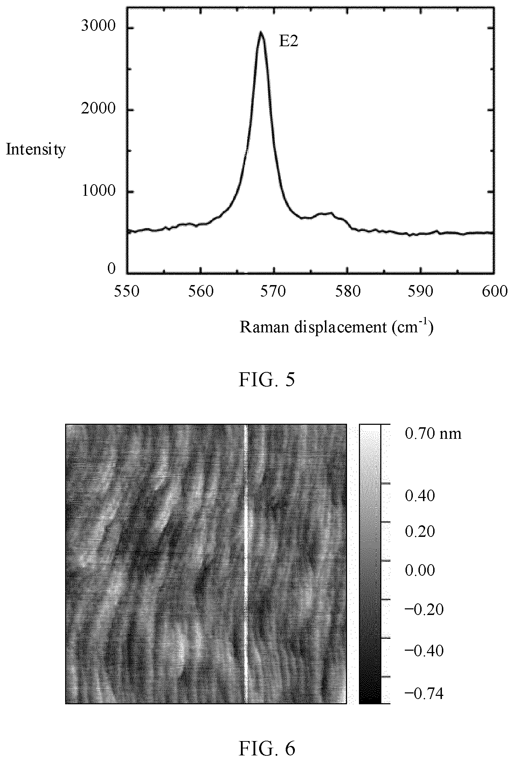

Raman detection is performed on the gallium nitride epitaxial wafer obtained in Embodiment 1 by using a Raman spectrometer. A Raman scattering graph of a surface of the epitaxial layer is shown in FIG. 5. It can be learned from FIG. 5 that a Raman peak E2 (E2_{Hight}) is approximately 568 cm⁻¹, and is basically the same as a standard Raman peak of gallium nitride, indicating that the gallium nitride epitaxial layer is basically in a stress-free state. E2 is a Raman peak of gallium nitride that is strongly related to the stress. An offset between the Raman peak of gallium nitride and the standard peak is obtained through comparison, to determine a stress type (a leftward offset indicates a tensile stress, and a rightward offset indicates a compressive stress) and a magnitude.

In addition, FIG. 6 shows an atomic force microscope (Atomic Force Microscope, AFM) picture of an epitaxial layer of a gallium nitride epitaxial wafer obtained in Embodiment 1. It can be learned from FIG. 6 that an obvious step flow is presented on the surface of the gallium nitride epitaxial layer, indicating good crystal quality. RMS (root mean square roughness) is only 0.176 nm, indicating good flatness.

## Claims

1. A nitride epitaxial wafer (100), comprising:
a substrate (10);
a nucleation layer (20), formed on the substrate (10), wherein the nucleation layer (20) is an aluminum nitride layer or a gallium nitride layer;
a two-dimensional material layer (30), formed on the nucleation layer (20), wherein the two-dimensional material layer (30) is a non-continuous film, the two-dimensional material layer (30) includes a plurality of two-dimensional material films (301), a gap exists between some or any two adjacent two-dimensional material films (301), wherein a thickness of the two-dimensional material layer (30) is less than or equal to 1 nm, wherein the two-dimensional material layer (30) is a single-layer two-dimensional material; and
an epitaxial layer (40), formed on the two-dimensional material layer (30), wherein a material of the epitaxial layer (40) comprises a group III metal nitride, wherein each of the plurality of two-dimensional material films (301) is arranged between the nucleation layer and the epitaxial layer and is arranged to provide a spacing therebetween,
wherein a width of the gap is greater than or equal to 0.1 µm, and is less than or equal to 1/2 of a maximum distance between two points on each two-dimensional material film (301),
wherein the epitaxial layer (40) does not directly bond with the nucleation layer (20),
wherein the epitaxial layer (40) partially covers the nucleation layer (20) and has the same peripheral contour as the two-dimensional material layer (30).

2. The nitride epitaxial wafer (100) according to claim 1, wherein an area percentage of the two-dimensional material layer (30) at the nucleation layer (20) is not less than 50%.

3. The nitride epitaxial wafer (100) according to claim 1, wherein a shape of the two-dimensional material film (301) is a polygon.

4. The nitride epitaxial wafer (100) according to claim 3, wherein the shape of the two-dimensional material film (301) is an equilateral triangle, a right triangle, a regular hexagon, a square, a rectangle, or a diamond.

5. The nitride epitaxial wafer (100) according to any one of claims 1 to 4, wherein a material of the two-dimensional material layer (30) comprises at least one of graphene, boron nitride, silicene, germanene, phosphorene, borophene, stanene, a transition metal sulfide, a transition metal carbide, and a transition metal nitride.

6. The nitride epitaxial wafer (100) according to claim 1, wherein, the substrate (10) comprises a silicon substrate, a sapphire substrate, a silicon on insulator substrate, a gallium nitride substrate, a gallium arsenide substrate, an indium phosphide substrate, an aluminum nitride substrate, a silicon carbide substrate, a quartz substrate, or a diamond substrate.

7. The nitride epitaxial wafer (100) according to claim 1, wherein a thickness of the nucleation layer (30) is 10 nm to 300 nm.

8. The nitride epitaxial wafer (100) according to claim 1, further comprising a transition layer (50) disposed between the two-dimensional material layer (30) and the epitaxial layer (40), and the transition layer (50) is an aluminum nitride layer or a gallium nitride layer.

9. The nitride epitaxial wafer (100) according to claim 8, wherein the transition layer (50) and the nucleation layer (20) have a same material.

10. A semiconductor device, comprising the nitride epitaxial wafer (100) according to any one of claims 1 to 9.

## Patentansprüche

1. Epitaktischer Nitridwafer (100), umfassend:
ein Substrat (10);
eine Keimbildungsschicht (20), die auf dem Substrat (10) ausgebildet ist, wobei die Keimbildungsschicht (20) eine Aluminiumnitridschicht oder eine Galliumnitridschicht ist;
eine zweidimensionale Materialschicht (30), die auf der Keimbildungsschicht (20) ausgebildet ist, wobei die zweidimensionale Materialschicht (30) ein nicht zusammenhängender Film ist, die zweidimensionale Materialschicht (30) eine Vielzahl von zweidimensionalen Materialfilmen (301) umfasst, ein Spalt zwischen einigen oder zwei beliebigen benachbarten zweidimensionalen Materialfilmen (301) besteht, wobei eine Dicke der zweidimensionalen Materialschicht (30) kleiner oder gleich 1 nm ist, wobei die zweidimensionale Materialschicht (30) ein einschichtiges zweidimensionales Material ist; und
eine epitaktische Schicht (40), die auf der zweidimensionalen Materialschicht (30) ausgebildet ist, wobei ein Material der epitaktischen Schicht (40) ein Gruppe-III-Metallnitrid umfasst, wobei jeder der Vielzahl von zweidimensionalen Materialfilmen (301) zwischen der Keimbildungsschicht und der epitaktischen Schicht angeordnet ist und angeordnet ist, um einen Abstand dazwischen bereitzustellen,
wobei eine Breite des Spalts größer oder gleich 0,1 µm ist und kleiner oder gleich 1/2 einer maximalen Distanz zwischen zwei Punkten auf jedem zweidimensionalen Materialfilm (301) ist, wobei sich die epitaktische Schicht (40) nicht direkt mit der Keimbildungsschicht (20) verbindet,
wobei die epitaktische Schicht (40) die Keimbildungsschicht (20) teilweise bedeckt und dieselbe Umfangskontur wie die zweidimensionale Materialschicht (30) aufweist.

2. Epitaktischer Nitridwafer (100) nach Anspruch 1, wobei ein Flächenanteil der zweidimensionalen Materialschicht (30) an der Keimbildungsschicht (20) nicht weniger als 50 % beträgt.

3. Epitaktischer Nitridwafer (100) nach Anspruch 1, wobei eine Form des zweidimensionalen Materialfilms (301) ein Polygon ist.

4. Epitaktischer Nitridwafer (100) nach Anspruch 3, wobei die Form des zweidimensionalen Materialfilms (301) ein gleichseitiges Dreieck, ein rechtwinkliges Dreieck, ein regelmäßiges Sechseck, ein Quadrat, ein Rechteck oder eine Raute ist.

5. Epitaktischer Nitridwafer (100) nach einem der Ansprüche 1 bis 4, wobei ein Material der zweidimensionalen Materialschicht (30) mindestens eines von Graphen, Bornitrid, Silicen, Germanen, Phosphoren, Borophen, Stanen, einem Übergangsmetallsulfid, einem Übergangsmetallcarbid und einem Übergangsmetallnitrid umfasst.

6. Epitaktischer Nitridwafer (100) nach Anspruch 1, wobei das Substrat (10) ein Siliziumsubstrat, ein Saphirsubstrat, ein Silizium-auf-Isolator-Substrat, ein Galliumnitrid-Substrat, ein Galliumarsenid-Substrat, ein Indiumphosphid-Substrat, ein Aluminiumnitrid-Substrat, ein Siliziumcarbid-Substrat, ein Quarzsubstrat oder ein Diamantsubstrat umfasst.

7. Epitaktischer Nitridwafer (100) nach Anspruch 1, wobei eine Dicke der Keimbildungsschicht (30) 10 nm bis 300 nm beträgt.

8. Epitaktischer Nitridwafer (100) nach Anspruch 1, ferner umfassend eine Übergangsschicht (50), die zwischen der zweidimensionalen Materialschicht (30) und der epitaktischen Schicht (40) angeordnet ist, und die Übergangsschicht (50) eine Aluminiumnitridschicht oder eine Galliumnitridschicht ist.

9. Epitaktischer Nitridwafer (100) nach Anspruch 8, wobei die Übergangsschicht (50) und die Keimbildungsschicht (20) dasselbe Material aufweisen.

10. Halbleitervorrichtung, umfassend den epitaktischen Nitridwafer (100) nach einem der Ansprüche 1 bis 9.

## Revendications

1. Tranche épitaxiale de nitrure (100), comprenant :
un substrat (10) ;
une couche de nucléation (20), formée sur le substrat (10), dans laquelle la couche de nucléation (20) est une couche de nitrure d'aluminium ou une couche de nitrure de gallium ;
une couche de matériau bidimensionnel (30), formée sur la couche de nucléation (20), dans laquelle la couche de matériau bidimensionnel (30) est un film non continu, la couche de matériau bidimensionnel (30) comporte une pluralité de films de matériau bidimensionnel (301), un espace existant entre certains ou entre deux films quelconques de matériau bidimensionnel (301) adjacents, dans laquelle une épaisseur de la couche de matériau bidimensionnel (30) est inférieure ou égale à 1 nm, dans laquelle la couche de matériau bidimensionnel (30) est un matériau bidimensionnel monocouche ; et
une couche épitaxiale (40), formée sur la couche de matériau bidimensionnel (30), dans laquelle un matériau de la couche épitaxiale (40) comprend un nitrure de métal du groupe III, dans laquelle chacun de la pluralité de films de matériau bidimensionnel (301) est agencé entre la couche de nucléation et la couche épitaxiale et est agencé de manière à fournir un espacement entre elles,
dans laquelle une largeur de l'espace est supérieure ou égale à 0,1 µm et inférieure ou égale à la moitié d'une distance maximale entre deux points sur chaque film de matériau bidimensionnel (301),
dans laquelle la couche épitaxiale (40) ne se lie pas directement à la couche de nucléation (20),
dans laquelle la couche épitaxiale (40) recouvre partiellement la couche de nucléation (20) et a le même contour périphérique que la couche de matériau bidimensionnel (30).

2. Tranche épitaxiale de nitrure (100) selon la revendication 1, dans laquelle un pourcentage de surface de la couche de matériau bidimensionnel (30) au niveau de la couche de nucléation (20) n'est pas inférieur à 50 %.

3. Tranche épitaxiale de nitrure (100) selon la revendication 1, dans laquelle une forme du film de matériau bidimensionnel (301) est un polygone.

4. Tranche épitaxiale de nitrure (100) selon la revendication 3, dans laquelle la forme du film de matériau bidimensionnel (301) est un triangle équilatéral, un triangle rectangle, un hexagone régulier, un carré, un rectangle ou un losange.

5. Tranche épitaxiale de nitrure (100) selon l'une quelconque des revendications 1 à 4, dans laquelle un matériau de la couche de matériau bidimensionnel (30) comprend au moins l'un du graphène, du nitrure de bore, du silicène, du germanène, du phosphorène, du borophène, du stanène, d'un sulfure de métal de transition, d'un carbure de métal de transition et d'un nitrure de métal de transition.

6. Tranche épitaxiale de nitrure (100) selon la revendication 1, dans laquelle le substrat (10) comprend un substrat de silicium, un substrat de saphir, un substrat de silicium sur isolant, un substrat de nitrure de gallium, un substrat d'arséniure de gallium, un substrat de phosphure d'indium, un substrat de nitrure d'aluminium, un substrat de carbure de silicium, un substrat de quartz ou un substrat de diamant.

7. Tranche épitaxiale de nitrure (100) selon la revendication 1, dans laquelle une épaisseur de la couche de nucléation (30) est de 10 nm à 300 nm.

8. Tranche épitaxiale de nitrure (100) selon la revendication 1, comprenant également une couche de transition (50) disposée entre la couche de matériau bidimensionnel (30) et la couche épitaxiale (40), et la couche de transition (50) est une couche de nitrure d'aluminium ou une couche de nitrure de gallium.

9. Tranche épitaxiale de nitrure (100) selon la revendication 8, dans laquelle la couche de transition (50) et la couche de nucléation (20) ont le même matériau.

10. Dispositif semi-conducteur comprenant la tranche épitaxiale de nitrure (100) selon l'une quelconque des revendications 1 à 9.
